# EUROPÄISCHE PATENTANMELDUNG

(11) **EP 0 559 082 A1**
(43) Veröffentlichungstag der Anmeldung: **08.09.1993**
(21) Anmeldenummer: 93103003.5
(22) Anmeldetag: 26.02.1993
(51) Int. Cl.: H05K 9/00

(54) **Elektrisches Installationsgerät**

(30) Priorität: 04.03.1992 DE 9202833 U
(71) Anmelder: ABB PATENT GmbH, D-68309 Mannheim (DE)
(72) Erfinder: Eberwein, Helmut, W-5880 Lüdenscheid (DE)
(74) Vertreter: Rupprecht, Klaus, Dipl.-Ing.

(57) **Zusammenfassung**

Die Erfindung betrifft ein elektrisches Installationsgerät, z. B. Drehzahlsteller oder Bus-Komponente, mit einem Gehäuse (20, 22) zur Aufnahme elektronischer Bauteile, welches zum Schutz vor elektrischen und/oder elektromagnetischen Feldern mit einer Abschirmung versehen ist, wobei das Gehäuse (20, 22) aus Isolierstoff besteht und eine elektrisch leitende Schicht (24) aufweist, die als Abschirmung dient.

## Beschreibung

Die Erfindung betrifft ein elektrisches Installationsgerät, z. B. Drehzahlsteller, Bussystem-Anschluß, mit einem Gehäuse zur Aufnahme elektronischer Bauteile, welches zum Schutz vor elektrischen und/oder elektromagnetischen Feldern mit einer Abschirmung versehen ist.

Es ist bekannt, daß elektrische und/oder elektromagnetische Felder die bestimmungsgemäße Funktion elektronischer Bauteile beeinflussen können. Neuere elektrische Installationsgeräte, die elektronische Schaltungen aufweisen, z. B. Dimmer, Drehzahlsteller oder Bus-Systemkomponenten, können durch derartige Felder gestört und in ihrer Funktion beeinträchtigt werden.

Zur Vermeidung derartiger Störungen ist es bekannt, Abschirmungen aus Metall bzw. Metallfolien zu benutzen, welche die elektronische Schaltung möglichst strahlungsdicht umschließen, so daß eine Beeinflussung durch äußere Felder praktisch ausgeschlossen ist. Solche Abschirmgehäuse werden je nach Größe des zu umschließenden Volumens als ein- oder mehrteiliges zusätzliches Formteil, z. B. aus Blech, vorgesehen, in welches die zu schützende Schaltung eingesetzt wird.

Ein derartiges zusätzliches erforderliches Metallgehäuse verursacht sowohl zusätzliche Material- und Lagerkosten als auch zusätzliche Aufwendungen bezüglich der Fertigungskosten und der Fertigungsdauer.

Ausgehend von diesem Stand der Technik ist es daher Aufgabe der Erfindung, ein elektrisches Installationsgerät der Eingangs genannten Art zu schaffen, das einfach aufgebaut und kostengünstig herstellbar ist, wobei die erforderliche Abschirmung den Montageablauf möglichst nicht beeinträchtigen soll.

Die Lösung der Aufgabe besteht erfindungsgemäß in den kennzeichnenden Merkmalen des Patentanspruchs 1. Danach ist vorgesehen, daß das Gehäuse aus Isolierstoff besteht und mit einer elektrisch leitenden Schicht versehen ist, die als Abschirmung dient.

Das Gehäuse kann aus einem Thermoplast oder aus einem Duromer bestehen, wobei die elektrisch leitende Schicht abhängig von der besonderen Art des elektrischen Installationsgerätes sowie dem vorgesehenen Verwendungszweck auf der Außenoberfläche oder auf der Innenoberfläche angeordnet sein kann.

Zur Erhöhung der Wirksamkeit der Abschirmung kann auch eine doppelte Beschichtung d. h. auf der Innen- und auf der Außenoberfläche des Gerätes vorgesehen sein kann.

Die elektrisch leitende Schicht kann mittels Aufdampfen oder galvanisch auf der Gehäuseoberfläche angebracht sein. Darüber hinaus besteht die Möglichkeit die Schicht in Form eines Leitlackes auf die Gehäuseoberfläche aufzutragen oder aber das Gehäuse mit einer photo-chemisch reaktiven, z. B. metall-organischen, Substanz zu beaufschlagen, welche unter Einwirkung bestimmter Strahlung zur Bildung einer Metallschicht auf der Gehäuseoberfläche führt.

In zweckmäßiger Weiterbildung des erfindungsgemäßen elektronischen Installationsgerätes kann vorgesehen sein, daß das Gehäuse einen abnehmbaren Deckel aufweist, der entsprechend dem übrigen Gehäuse entweder auf der Außen- oder auf der Innenoberfläche mit einer elektrisch leitenden Schicht versehen ist.

Gegebenenfalls kann, z. B. aus Design- oder Funktionsgründen der Deckel innenbeschichtet sein, obwohl das übrige Gehäuse die elektrisch leitende Schicht auf seiner Außenoberfläche aufweist oder umgekehrt.

In zweckmäßiger Weiterbildung der Erfindung besitzt das Gehäuse Durchbrüche, welche dazu dienen Verbindungsleitungen, Stecker oder ähnliche Verbindungselemente in das Gehäuseinnere einzuführen, um so die Verbindung mit der darin angeordneten elektronischen Schaltung herzustellen.

Diese und weitere vorteilhafte Ausgestaltungen der Erfindung sind Gegenstand der Unteransprüche.

Anhand eines Ausführungsbeispieles sollen die Erfindung, vorteilhafte Ausgestaltungen und besondere Vorteile der Erfindung erläutert und beschrieben werden.

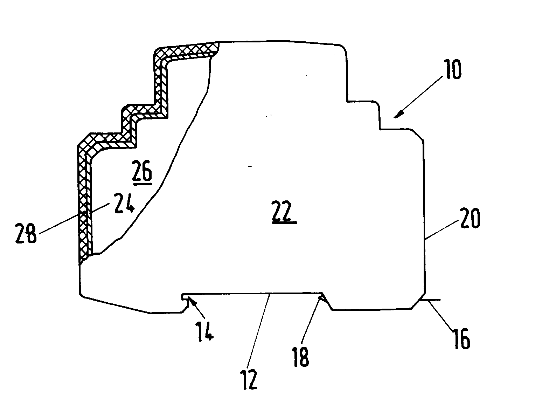

Es zeigt die einzige Figur ein Reiheneinbaugerät in Seitenansicht mit Teilschnitt.

In der einzigen Figur ist ein elektrisches Installationsgerät 10 dargestellt, das als Reiheneinbaugerät ausgebildet ist und zur Montage in Verteilungen vorgesehen ist.

Zur Befestigung auf den dort üblicherweise vorgesehenen Hutprofil-Tragschienen besitzt das Installationsgerät 10 auf seiner Rückseite, die in der hier gezeigten Darstellung nach unten weist, eine entsprechende Ausnehmung 12 mit einer ortsfesten Dreieckkerbe 14 und einer veränderlichen, von einem Schieber 16 gebildeten Haltekerbe 18.

Das elektrische Installationsgerät 10 besitzt ein Gehäuse 20 mit einem Deckel 22, der in der hier gezeigten Darstellung teilweise geschnitten ist, so daß der Blick ins Innere des Gehäuses 20 freigegeben ist.

Das Gehäuse 20 sowie der Deckel 22 bestehen aus Isolierstoff, vorzugsweise ein Duromer, und sind als Spritzgußteile gefertigt. Hierdurch ist eine gleichbleibende Herstellqualität gesichert.

Zur Abschirmung gegen elektrische und/oder elektromagnetische Felder, welche einerseits von außen die innerhalb des Gehäuses 20 des Installationsgeräts 10 befindliche, hier nicht näher gezeigte elektronische Schaltung beeinflussen können, als auch zur Abschirmung gegen Störstrahlungen, die von der im Gehäuse 20 befindlichen Schaltung ausgehen können, dient eine elektrisch leitende Schicht 24, welche auf der Innenoberfläche 26 der das Gehäuse 20 bildenden Wandung 28 angebracht ist.

In der gezeigten Darstellung ist diese elektrisch leitende Schicht 24 im Verhältnis zur Wandstärke wesentlich dicker, als sie am konkreten Bauteil tatsächlich vorliegt.

Die Dicke des Gehäuses und damit das umschlossene Volumen richtet sich unter Berücksichtigung der standardisierten Modulmaße von 17,5 mm nach dem jeweiligen Zweck und dem davon abhängigen Raumbedarf des jeweiligen Installationsgerätes 10.

## Patentansprüche

1. Elektrisches Installationsgerät, z. B. Drehzahlsteller, Bus-Komponenten, mit einem Gehäuse zur Aufnahme elektronischer Bauteile, welches zum Schutz vor elektrischen und/oder elektromagnetischen Feldern mit einer Abschirmung versehen ist, dadurch gekennzeichnet, daß das Gehäuse (20) aus Isolierstoff besteht und eine elektrisch leitende Schicht (24) aufweist, die als Abschirmung dient.

2. Elektrisches Installationsgerät nach Anspruch 1, dadurch gekennzeichnet, daß das Gehäuse (20) einen abnehmbaren Deckel (22) besitzt.

3. Elektrisches Installationsgerät nach einem der Ansprüche 1 oder 2, dadurch gekennzeichnet, daß das Gehäuse (20, 22) aus einem Thermoplast besteht.

4. Elektrisches Installationsgerät nach einem der Ansprüche 1 oder 2, dadurch gekennzeichnet, daß das Gehäuse (20, 22) aus einem Duromer besteht.

5. Elektrisches Installationsgerät nach einem der vorherigen Ansprüche, dadurch gekennzeichnet, daß die elektrisch leitende Schicht (24) auf der Außenoberfläche des Gehäuses (20, 22) vorgesehen ist.

6. Elektrisches Installationsgerät nach einem der Ansprüche 1 bis 4, dadurch gekennzeichnet, daß die elektrisch leitende Schicht (24) auf der Innenoberfläche (26) des Gehäuses (20, 22) vorgesehen ist.

7. Elektronisches Installationsgerät nach einem der Ansprüche 1 bis 4, dadurch gekennzeichnet, daß die elektrisch leitende Schicht (24) auf der Innenoberfläche (26) sowie auf der Außenoberfläche des Gehäuses (20, 22) vorgesehen ist.

8. Elektrisches Installationsgerät nach einem der vorherigen Ansprüche, dadurch gekennzeichnet, daß die elektrisch leitende Schicht (24) mittels Aufdampfen gebildet ist.

9. Elektrisches Installationsgerät nach einem der Ansprüche 1 bis 7, dadurch gekennzeichnet, daß die elektrisch leitende Schicht (24) ein Leitlack ist, der auf die Oberfläche des Gehäuses (20, 22) aufgetragen ist.

10. Elektrisches Installationsgerät nach einem der Ansprüche 1 bis 7, dadurch gekennzeichnet, daß die elektrisch leitende Schicht (24) galvanisch auf die Oberfläche des Gehäuses (20, 22) aufgetragen ist.

11. Elektrisches Installationsgerät nach einem der Ansprüche 1 bis 7, dadurch gekennzeichnet, daß die elektrisch leitende Schicht (24) aus einer photo-chemisch reaktiven Substanz gebildet ist.

12. Elektrisches Installationsgerät, dadurch gekennzeichnet, daß das Gehäuse (20, 22) Durchbrüche aufweist, durch welche Leiter, Stecker und ähnlich Verbindungselemente ins Innere des Gehäuses (20, 22) einführbar sind.

13. Elektrisches Installationsgerät nach einem der vorherigen Ansprüche, dadurch gekennzeichnet, daß das Gehäuse (20, 22) als Reiheneinbaugerät zur Befestigung auf Hutprofil-Tragschienen ausgebildet ist.

14. Elektrisches Installationsgerät nach einem der Ansprüche 1 bis 12, dadurch gekennzeichnet, daß das Gehäuse als kreiszylindrische Dose zum Wandeinbau ausgebildet ist.
